## Europäisches Patentamt

## European Patent Office

## Office européen des brevets

(19)

(11) Veröffentlichungsnummer: **0 049 304**
**B1**

(12) # EUROPÄISCHE PATENTSCHRIFT

(45) Veröffentlichungstag der Patentschrift:
**29.05.85**

(51) Int. Cl.⁴: **G 01 D 3/04**

(21) Anmeldenummer: **80106092.2**

(22) Anmeldetag: **07.10.80**

(54) **Verfahren zur Kompensation von temperaturbedingten Messfehlern bei Wechselstrom-Messschaltungen, insbesondere Abstandsmessgeräten sowie Vorrichtung zur Durchführung des Verfahrens.**

(43) Veröffentlichungstag der Anmeldung:
**14.04.82 Patentblatt 82/15**

(45) Bekanntmachung des Hinweises auf die Patenterteilung:
**29.05.85 Patentblatt 85/22**

(84) Benannte Vertragsstaaten:
**AT BE CH DE FR GB IT LI LU NL SE**

(56) Entgegenhaltungen:
**DE - A - 2 637 413**
**US - A - 4 190 804**

(73) Patentinhaber: **Micro-Epsilon Messtechnik GmbH & Co. Kommanditgesellschaft, Königbacher Strasse 15, D-8359 Ortenburg-Dorfbach (DE)**

(72) Erfinder: **Hrubes, Franz, Maierhof 102, D-8399 Rottalmünster (DE)**

(74) Vertreter: **Kador . Klunker . Schmitt-Nilson . Hirsch, Corneliusstrasse 15, D-8000 München 5 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

## Beschreibung

Die vorliegende Erfindung bezieht sich auf ein Verfahren zur Kompensation von temperaturbedingten Meßfehlern bei Wechselstrom-Meßschaltungen gemäß dem Oberbegriff des Anspruchs 1 sowie auf eine Vorrichtung zur Durchführung dieses Verfahrens.

Nach dem Wirbelstromprinzip arbeitende berührungslose Abstandsmeßgeräte besitzen eine induktive Meßspule, welche in einem gewissen Abstand zu einem metallischen Meßobjekt angeordnet ist. Die mit einem Wechselstrom höherer Frequenz beschickte Meßspule, welche als Primärwicklung eines Transformators angesehen werden kann, induziert innerhalb des metallischen Meßobjekts Wirbelströme, demzufolge das metallische Meßobjekt der kurzgeschlossenen Sekundärwicklung des Transformators entspricht. Die Größe der in dem Meßobjekt induzierten Wirbelströme ist dabei abhängig von dem Abstand zwischen Meßspule und Meßobjekt, so daß die Größe des Wirbelstromes ein Maß für den Abstand der induktiv gekoppelten Elemente ist.

Zur Messung der Wirbelstromverluste innerhalb der durch das Meßobjekt gebildeten Sekundärwicklung ist die Meßspule über eine Meßleitung mit einem Kondensator verbunden und bildet mit demselben einen Resonanzkreis. Da die in dem Meßobjekt induzierten Wirbelströme sich als Ohmsche Verluste niederschlagen, kann durch Messung der Güte des Resonanzkreises, d. h. also im wesentlichen durch Messung der Schwingungsamplitude, die Größe der Wirbelströme und damit der gegenseitige Abstand der induktiv gekoppelten Elemente bestimmt werden.

Während früher zur Erzielung höherer Induktivitätswerte und einer besseren Kraftlinienausrichtung in der Regel Meßspulen mit einem einseitig offenen Ferritschalenkern verwendet wurden (siehe beispielsweise DE-A-2 637 413), besteht heutzutage im Hinblick auf die Erzielung höherer Meßgenauigkeiten die Tendenz, kernlose Luftspulen in Verbindung mit höheren Signalfrequenzen zu verwenden, weil einerseits dadurch die Eisenverluste des Ferritkerns zum Wegfall gebracht werden, während andererseits durch Ausnutzung des Hauteffektes die Meßebene im Bereich des Meßobjektes genauer definierbar ist.

Auf diese Weise lassen sich heutzutage Genauigkeiten der Abstandsmessung bis herunter zu 0,1 Promille in Abstandsbereichen zwischen 0 und 0,5 mm und 0 und 100 mm je nach Größe der verwendeten Meßspule erreichen. Derartige berührungslose Abstandsmeßgeräte werden dabei bei dynamischen Vorgängen zur Bestimmung von Schwingungen, Exzentrizitäten und Deformationen verschiedenster Maschinenteile, insbesondere Walzen und Wellen, verwendet, während in Bezug auf statische Vorgänge eine Verwendung derselben beispielsweise in Fertigungsstraßen und bei der Endabnahme möglich ist.

Die heutzutage zur Verfügung stehenden induktiven Abstandsmeßgeräte sind im Bezug auf ihre Meßsonden auf einen Temperaturbereich zwischen −40 und +150°C ausgelegt. Es ist dabei einleuchtend, daß ein derart breiter Temperaturbereich zu nicht vernachlässigbaren Meßfehlern führt, weil in Abhängigkeit der Temperatur der Ohmsche Widerstand nicht nur der die Primärwicklung bildenden Meßspule, sondern auch der innerhalb des Meßobjektes gebildeten kurzgeschlossenen Sekundärwicklung verändert wird, wobei beide Faktoren die Güte des durch Meßspule und Kondensator gebildeten Resonanzkreises beeinflussen.

Um diese temperaturbedingten Meßfehler korrigieren zu können, ist es bereits bekannt, im Bereich der Meßspule Temperaturfühler in Form von Thermoelementen oder Hilfswicklungen vorzusehen, um auf diese Weise ein Temperatursignal abzuleiten. Derartige im Bereich der Meßspule angeordnete Temperaturfühler haben jedoch den Nachteil, daß der Aufbau der Meßsonde dadurch kompliziert wird, wobei gleichzeitig ein zusätzliches Meßkabel notwendig wird.

Es ist demzufolge Aufgabe der vorliegenden Erfindung, das Verfahren der eingangs genannten Art dahingehend weiterzubilden, daß unter Vermeidung zusätzlicher Elemente eine Kompensation von temperaturbedingten Meßfehlern bei Wechselstrommeßschaltungen insbesondere induktiven Abstandsmeßgeräten möglich ist.

Erfindungsgemäß wird dies durch die im Anspruch 1 aufgeführten Merkmale erreicht.

Durch das zusätzliche Einspeisen von Gleichstrom oder einem niederfrequenten Wechselstrom in den Meßkreis ergibt sich die Möglichkeit, einen Spannungswert zu bilden, welcher im wesentlichen proportional zum Ohmschen Widerstand der betreffenden Impedanz ist. Mit Hilfe dieses Spannungswertes läßt sich somit ein der Temperatur entsprechendes Korrektursignal ableiten, mit welchem das höherfrequente Wechselstromsignal korrigiert werden kann. Dieser Korrekturvorgang kann innerhalb der Wechselstrommeßschaltung durchgeführt werden, so daß am Ausgang der Meßschaltung ein von Temperatureinflüssen bereinigtes Meßsignal abgegeben wird.

Vorteilhafte Weiterbildungen des erfindungsgemäßen Verfahrens ergeben sich anhand der abhängigen Ansprüche 2 und 3. Im unabhängigen Anspruch 4 ist eine Vorrichtung zur Durchführung des Verfahrens angegeben.

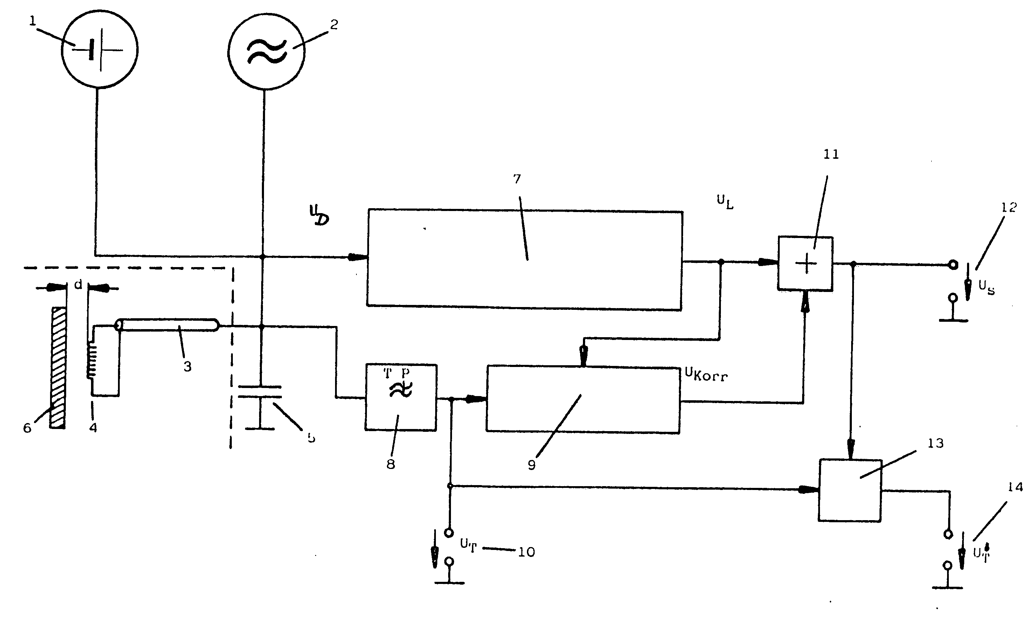

Die Erfindung soll nunmehr anhand eines Ausführungsbeispiels näher erläutert und beschrieben werden, wobei auf die beigefügte Zeichnung Bezug genommen ist, welche ein vereinfachtes Blockschaltbild eines induktiven Abstandsmeßgerätes mit Kompensation von temperaturbedingten Meßfehlern zeigt.

Gemäß der Figur zeigt das induktive Abstandsmeßgerät eine Gleichspannungsquelle 1 und einen Wechselstromgenerator 2 auf, welche über ein koaxiales Meßkabel 3 eine als Luftspule ausgebildete Meßspule 4 speisen. Die Meßspule 4 ist über das Koaxial-Kabel 3 mit einem Kondensator 5 verbunden und bildet mit demselben einen Parallel-Resonanzkreis. In der Nähe der Meßspule 4 befindet sich ein metallisches Meßobjekt 6, dessen Abstand d in Bezug auf die Meßspule 4 gemessen werden soll.

Auf der Ausgangsseite des durch die Meßspule 4 und den Kondensator 5 gebildeten Resonanzkreises ist einerseits eine Signalaufbereitungseinheit 7 und andererseits ein Tiefpaßfilter 8 mit einer daran angeschlossenen Korrektureinheit 9 vorgesehen. Der Ausgang des Tiefpaßfilters 8 führt zusätzlich zu einer Ausgangsklemme 10, an welcher eine der Temperatur der Meßspule 4 entsprechende Ausgangsspannung $U_T$ abnehmbar ist. Das Ausgangssignal der Signalaufbereitungseinheit 7 wird einerseits der Korrektureinheit 9 und andererseits einem Summierglied 11 zugeführt, welchem ebenfalls das Ausgangssignal der Korrektureinheit 9 zugeführt wird. Das Ausgangssignal des Summiergliedes 11 wird einer Ausgangsklemme 12 zugeführt, an welcher ein Spannungswert $U_S$ entsprechend einem temperaturkompensierten Abstandswert abnehmbar ist. Das Ausgangssignal des Summiergliedes 10 wird fernerhin einer weiteren Signalaufbereitungseinheit 13 zugeführt, welcher ebenfalls das Ausgangssignal des Tiefpaßfilters 8 zugeführt ist. Die Signalaufbereitungseinheit 13 ist mit einer Ausgangsklemme 14 verbunden, an welcher ein korrigiertes Temperatursignal $U_T{'}$ entsprechend der Temperatur des Meßobjektes 6 abnehmbar ist.

Die Funktionsweise des beschriebenen induktiven Abstandsmeßgerätes ist wie folgt: Der Wechselstromgenerator 2 besitzt einen hohen Innenwiderstand und speist somit den aus den Elementen 4 und 5 bestehenden Schwingkreis mit konstantem Wechselstrom mit einer Frequenz von etwa 1 Megahertz. Aufgrund des innerhalb der Meßspule 4 gebildeten Wechselmagnetfeldes werden innerhalb des Meßobjektes 6 Wirbelströme induziert, so daß das Meßobjekt 6 als Sekundärwicklung eines Transformators wirkt, wobei die Primärwicklung durch die Meßspule 4 gebildet ist. Entsprechend dem Abstand d zwischen Meßobjekt 6 und Meßspule 4 ändert sich die Größe der in dem Meßobjekt 6 induzierten Wechselströme, welche zu Ohmschen Verlusten innerhalb des Meßobjektes 6 führen. Diese Ohmschen Verluste innerhalb des Meßobjektes 6 zusammen mit den Ohmschen Verlusten innerhalb der Meßspule 4 und des Meßkabels 3 bedämpfen den durch die Meßspule 4 und den Kondensator 5 gebildeten Parallel-Resonanzkreis, so daß die am Ausgang des durch die Elemente 4 und 5 gebildeten Resonanzkreises auftretende Wechselspannung $U_D$ ein Maß für den Abstand d zwischen Meßobjekt 6 und Meßspule 4 ist.

Um eine Kompensation der temperaturbedingten Meßfehler durchführen zu können, ist im Rahmen der vorliegenden Erfindung eine Gleichstromquelle 1 vorgesehen, die aufgrund ihres hochohmigen Innenwiderstandes einen konstanten Gleichstrom an den durch die Meßspule 4 und den Kondensator 5 gebildeten Resonanzkreis abgibt. Aufgrund des Ohmschen Widerstandes der Meßspule 4 wird an derselben ein Gleichspannungswert $U_T$ gebildet, der über den Tiefpaßfilter 8 hinweg an der Ausgangsklemme 10 abgenommen werden kann. Dieser Gleichspannungswert $U_T$ entspricht dabei dem Ohmschen Widerstand der Meßspule 4 und ist somit ein Maß für die Temperatur der Meßspule 4.

Der Spannungswert $U_T$ wird fernerhin der Korrektureinheit 9 zugeführt, die eine Signalumsetzung in ein Korrektursignal $U_{Korr}$ durchführt. Auf der anderen Seite wird das von dem Resonanzkreis abgegebene Wechselstromsignal $U_D$ der Signalaufbereitungseinheit 7 zugeführt, in welcher eine Demodulation des Signals sowie eine Linearisierung in Bezug auf den Abstand d vorgenommen wird. Das auf diese Weise gebildete abstandslinearisierte Ausgangssignal $U_L$ wird dem Summierglied 11 zugeführt, welchem ebenfalls das Korrektursignal $U_{Korr}$ der Korrektureinheit 9 zugeführt ist. Auf diese Weise wird dann ein Abstandssignal $U_S$ gebildet, das an der Ausgangsklemme 12 verfügbar ist. Im Hinblick auf die Tatsache, daß das Meßobjekt 6 und die Meßspule 4 in der Regel aus unterschiedlichen Materialien bestehen — bei dem Meßobjekt 6 handelt es sich in der Regel um Eisen, während die Meßspule 4 aus Kupfer besteht —, die Elemente 4 und 6 somit unterschiedliche Temperaturkoeffizienten besitzen, während auf der anderen Seite das Verhältnis zwischen primär- und sekundärseitig innerhalb der Elemente 4 und 6 auftretenden Verluste sich mit zunehmendem Abstand verändert, wird im Rahmen der vorliegenden Erfindung zusätzlich das Ausgangssignal der Signalaufbereitungseinheit 7 der Korrektureinheit 9 zugeführt, damit bei der Bildung des Korrektursignals $U_{Korr}$ die Abstandsabhängigkeit noch berücksichtigt werden kann. Innerhalb der Korrektureinheit 9 werden somit zur Bildung des Korrektursignals $U_{Korr}$ sowohl das Temperatursignal $U_T$ wie auch das linearisierte Abstandssignal $U_L$ verarbeitet.

In vielen Fällen besteht der Wunsch, mit Hilfe einer zusätzlichen Schaltung auch eine Meßgröße zu bilden, welche der Temperatur des Meßobjektes 6 entspricht. Bei dem Meßobjekt 6 handelt es sich in der Regel um ein relativ großvolumiges Bauteil mit großer thermischer Kapazität, während die Meßspule 4 sehr klein ist und demzufolge eine geringe thermische Kapazität besitzt. Die Meßspule 4 ist fernerhin weitgehend thermisch isoliert aufgehängt, so daß sie über die bestehende thermische Kopplung in etwa die Temperatur des Meßobjekts 6 annimmt. Bei Meßobjekten 6, deren Temperatur stark ober- oder unterhalb der Umgebungstemperatur liegt, hängt die Größe der Temperaturannäherung der Meßspule 4 an die Temperatur des Meßobjektes 6 von dem Abstand d ab. Um somit die Temperatur des Meßobjektes 6 bestimmen zu können, ist im Rahmen der vorliegenden Erfindung die Signalaufbereitungseinheit 13 vorgesehen, der neben dem Spannungswert $U_T$ entsprechend der Temperatur der Meßspule 4 zusätzlich das Abstandssignal $U_S$ zugeführt wird, so daß ein abstandskorrigiertes Temperatursignal $U_T'$ gebildet wird, welches der Temperatur des Meßobjektes 6 entspricht.

Es erscheint einleuchtend, daß anstelle des von der Gleichstromquelle 1 abgegebenen Gleichspannungssignals konstanten Stromwertes zur Bildung des Korrektursignals $U_{Korr}$ ebenfalls ein niederfrequentes Signal verwendet werden kann, in welchem Fall die Einheit 1 als niederfrequente Signalquelle ausgebildet sein muß.

Die Abgabe eines konstanten Stromwertes läßt sich dabei durch Vorsehen eines hohen Innenwiderstandes oder durch Einsetzen eines Vorwiderstandes im Ausgangskreis der Einheit 1 erreichen.

## Patentansprüche

1. Verfahren zur Kompensation temperaturbedingter Meßfehler einer Wechselstrommeßschaltung, die ein mit einem Wechselstrom gespeistes Meßorgan (4) mit einer bezüglich dieses Wechselstroms ohmschen und/oder induktiven Impedanz sowie einem temperaturabhängigen Gleichstromwiderstand aufweist und ein Meßsignal ($U_L$) auf der Frequenz des Wechselstroms abgibt, dadurch gekennzeichnet, daß

— durch das Meßorgan zusätzlich zu dem Wechselstrom ein gleich- oder niederfrequentes Signal konstanten Stromwerts geleitet wird, und
— anhand des dem gleich-oder niederfrequenten Signal zugeordneten Spannungsabfalls am Meßorgan ein die Temperatur des Meßorgans repräsentierendes Korrektursignal ($U_{Korr}$) gebildet wird,
— das Korrektursignal ($U_{Korr}$) zur Kompensation des Einflusses der Temperatur auf das Meßsignal ($U_L$) verwendet wird.

2. Verfahren nach Anspruch 1, dadurch gekennzeichnet, daß vor der Kompensation des Einflusses der Temperatur auf das Meßsignal ($U_L$) zunächst der Einfluß der Meßgröße auf das Korrektursignal ($U_{Korr}$) mit Hilfe des Meßsignals kompensiert wird.

3. Verfahren nach Anspruch 1 oder 2, dadurch gekennzeichnet, daß im Falle einer zur Abstandsmessung ausgebildeten, eine induktive Meßspule enthaltenden Wechselstrommeßschaltung aus dem bezüglich der Temperatur kompensierten Meßsignal ($U_L$) und dem Korrektursignal ($U_{Korr}$) ein der Temperatur des bezüglich seines Abstands zur Meßspule überwachten Objekts (6) entsprechendes Signal ($U_T'$) gebildet wird.

4. Vorrichtung zur Durchführung des Verfahrens nach Anspruch 1 bei einer Abstandsmeßschaltung, die eine in einem Schwingkreis angeordnete Meßspule (4), einen die Meßspule speisenden Wechselstromgenerator (2) und eine Auswerteschaltung (7) zur Erzeugung eines dem Abstand eines Meßobjekts (6) von der Meßspule entsprechenden Meßsignals ($U_L$) auf der Frequenz des Wechselstromgenerators enthält, gekennzeichnet durch

— eine weitere Stromquelle (1) zur Beaufschlagung der Meßspule (4) mit einem zusätzlichen konstanten oder bezüglich der Frequenz des Wechselstromgenerators niederfrequenten Hilfsstrom,
— ein Tiefpaßfilter (8) zur Ableitung eines dem Spannungsabfall des Hilfsstroms an der Meßspule (4) und damit der Temperatur der Meßspule entsprechenden Korrektursignals ($U_{Korr}$) aus der Spannung an der Meßspule,
— eine Korrektureinrichtung mit einem Summierglied (11) zur Überlagerung des Meßsignals ($U_L$) mit dem Korrektursignal ($U_{Korr}$).

5. Vorrichtung nach Anspruch 4, dadurch gekennzeichnet, daß die Korrektureinrichtung eine das Meß- und das Korrektursignal empfangende Korrektureinheit (9) zur Kompensation der Abhängigkeit des Korrektursignals vom Abstand zwischen Meßobjekt (6) und Meßspule (4) aufweist.

6. Vorrichtung nach Anspruch 4 oder 5, gekennzeichnet durch eine Signalverarbeitungsschaltung (13) zur Erzeugung eines der Temperatur des Meßobjekts entsprechenden Signals ($U_T'$) aus den Ausgangssignalen des Summierglieds (11) und des Tiefpaßfilters (8).

## Claims

1. A method of compensating errors caused by temperature changes in A.C. measuring devices comprising measuring means with impedances, in particular for inductive distance measuring equipment with measuring coils forming part of a resonant circuit, characterized in that a constant current having a frequency far below the distance-measuring frequency is supplied to said measuring means additionally to said distance-measuring frequency, whereby a compensated signal ($U_S$) being proportional to said distance is derived from an A.C. measuring signal ($U_d$) corrected by correcting signal ($U_{Korr}$) which in turn is achieved by a voltage ($U_T$) from the output of said measuring means.

2. A method as in claim 1, characterized in that both, said measuring signal ($U_d$) and said temperature signal ($U_T$), after being converted accordingly, are used to form said correction signal ($U_{Korr}$) to correct said measuring signal ($U_d$).

3. A method as in claim 1 or 2, characterized in that when being used for inductive distance measurement, both are used to form a corrected temperature signal ($U_T'$) corresponding to the temperature of the device under test, said corrected distance-signal (U$_s$) and said temperature-signal (U$_T$) corresponding to coil temperature.

4. A device for performing the method as claimed in any of claims 1 to 3, characterized in that the measuring coil (4) forming part of an oscillating circuit (4, 5) is connected with its supply-input to a higher-frequency A.C. generator (2) as well as to an equal- or low-frequency voltage source (1), whereas on the output a correction unit (9) is arranged after a low-pass filter (8) along with a signal processing unit (7) for said distance-dependent A.C. signal (U$_d$), and that said correction signal (U$_{Korr}$) of said correction unit (9) is fed to a summing unit (11) arranged on the output of said signal processing unit (7).

5. A device as in claim 4, characterized in that said output signal (U$_L$) of said signal processing unit (7) is also fed to correction unit (9).

6. A device as in claim 4 or 5, characterized in that a further signal processing unit (13) is provided, to which both are fed, said temperature signal (U$_T$) obtained by low-pass filter (8) as well as said linearized distance signal (U$_L$) given by summing unit (11).

**Revendications**

1. Procédé pour la compensation d'erreurs de mesure, dues à la température, d'un montage de mesure à courant alternatif qui présente un organe de mesure (4) alimenté par un courant alternatif et présentant une impédance ohmique et/ou inductive en ce qui concerne ce courant alternatif ainsi qu'une résistance au courant continu liée à la température et qui émet un signal de mesure (U$_L$) sur la fréquencve du courant alternatif, caractérisé par le fait que

— par l'organe de mesure est conduit, outre le courant alternatif, un signal à fréquence égale ou à basse fréquence, ayant une valeur de courant constante, et
— d'après la chute de tension correspondant au signal à fréquence égale ou à basse fréquence, sur l'organe de mesure, on forme un signal de correction (U$_{Korr}$) représentant la température de l'organe de mesure,
— on utilise le signal de correction (U$_{Korr}$) pour la compensation de l'influence de la température sur le signal de mesure (U$_L$).

2. Procédé selon la revendication 1, caractérisé par le fait qu'avant la compensation de l'influence de la temperature sur le signal de mesure (U$_L$), on compense tout d'abord l'influence de la grandeur mesurée sur le signal de correction (U$_{Korr}$) à l'aide du signal de mesure.

3. Procédé selon l'une des revendications 1 et 2, caractérisé par le fait que dans le cas d'un montage de mesure à courant alternatif conçu pour la mesure de distance, contenant une bobine inductive de mesure, en partant du signal de mesure (U$_L$) compensé en ce qui concerne la température et du signal de correction (U$_{Korr}$), on forme un signal (U$_T'$) correspondant à la température de l'objet (6), surveillé en ce qui concerne sa distance à la bobine de mesure.

4. Appareil pour la mise en oeuvre du procédé selon la revendication 1, dans le cas d'un montage de mesure de distance qui comporte une bobine de mesure (4) disposée dans un circuit oscillant, un générateur de courant alternatif (2) alimentant la bobine de mesure et un circuit d'interprétation (7) pour engendrer un signal de mesure (U$_L$) correspondant à la distance d'un objet de mesure (6) à la bobine de mesure, sur la fréquence du générateur de courant alternatif, caractérisé par:

— une autre source de courant (1) pour appliquer à la bobine de mesure (4) un courant auxiliaire constant ou à basse fréquence relativement à la fréquence du générateur de courant alternatif,
— un filtre passe-bas (8) pour tirer, de la tension à la bobine de mesure, un signal de correction (U$_{Korr}$) correspondant à la chute de tension du courant auxiliaire sur la bobine de mesure (4) et donc à la température de la bobine de mesure,
— un dispositif de correction muni d'un organe sommateur (11) pour superposer le signal de correction (U$_{Korr}$) au signal de mesure (U$_L$).

5. Appareil selon la revendication 4, caractérisé par le fait que le dispositif de correction présente une unité de correction (9) recevant le signal de mesure et le signal de correction, pour la compensation de l'incidence de la distance entre objet de mesure (6) et bobine de mesure (4) sur le signal de correction.

6. Appareil selon l'une des revendications 4 et 5, caractérisé par un circuit de traitement de signal (13) servant à engendrer, en partant des signaux de sortie de l'organe sommateur (11) et du filtre passe-bas (8), un signal (U$_T'$) correspondant à la température de l'objet de mesure.

0 049 304

$U_D$

7

$U_L$

11

12

$U_S$

d

3

$U_{Korr}$

TP

8

9

13

6 4 5

$U_T$ — 10

$U_T'$

14